Europäisches Patentamt

European Patent Office

Office européen des brevets

(11) Veröffentlichungsnummer: **0 477 600 A1**

## EUROPÄISCHE PATENTANMELDUNG

(21) Anmeldenummer: **91114776.7**

(22) Anmeldetag: **02.09.91**

(51) Int. Cl.5: **H01L 21/304**, H01L 21/58

(30) Priorität: **26.09.90 DE 4030446**

(43) Veröffentlichungstag der Anmeldung:
**01.04.92 Patentblatt 92/14**

(84) Benannte Vertragsstaaten:
**CH DE FR GB IT LI SE**

(71) Anmelder: **SIEMENS AKTIENGESELLSCHAFT**
**Wittelsbacherplatz 2**
**W-8000 München 2(DE)**

(72) Erfinder: **Schwarzbauer, Herbert, Dr.**
**Kössener Strasse 13 A**
**W-8000 München 70(DE)**

(54) **Verfahren zum Befestigen eines mit wenigstens einem Halbleiterbauelement versehenen Halbleiterkörpers auf einem Substrat.**

(57) Verfahren zum Befestigen eines mit wenigstens einem Bauelement versehenen Halbleiterkörpers (1) auf einem Substrat, bei dem die Unterseite des Halbleiterkörpers (1) mit einer ersten Kontaktierungsschicht (6) und einer diese abdeckenden Metallpulverschicht (10) und die Oberseite des Substrats mit einer zweiten Kontaktierungsschicht versehen werden und die beschichteten Flächen des Halbleiterkörpers und des Substrats unter Erhitzen zusammengepreßt werden. Besteht der Halbleiterkörper (1) aus einem Teil einer Halbleiterscheibe (11), die eine Vielzahl von gleichartigen oder ähnlichen Teilen aufweist, so werden die erste Kontaktierungsschicht (6) und die Metallpulverschicht (10) nach der Erfindung auf der Rückseite der Halbleiterscheibe (11) für alle Halbleiterkörper gemeinsam aufgebracht, wonach die Metallpulverschicht angesintert wird, die Halbleiterscheibe auf eine Klebefolie aufgeklebt wird, die Halbleiterscheibe anschließend entlang von den Halbleiterkörper umgebenden Trennungslinien an- oder durchgesägt wird und der vereinzelte Halbleiterkörper von der Klebefolie abgezogen und auf dem Substrat befestigt wird.

FIG 3

Die Erfindung bezieht sich auf ein Verfahren zum Befestigen eines mit wenigstens einem Halbleiterbauelement versehenen Halbleiterkörpers auf einem Substrat nach dem Oberbegriff des Patentanspruchs 1.

Verfahren dieser Art sind aus den europäischen Patentanmeldungen EP-A-0 242 626 und EP-A-0 330 895 bekannt. Das Substrat dient dabei zur Halterung des Halbleiterkörpers sowie zur Ableitung der im Halbleiterbauelement entstehenden Wärme, was insbesondere bei Leistungshalbleiterbauelementen von Bedeutung ist.

Der Erfindung liegt die Aufgabe zugrunde, ein Verfahren der eingangs genannten Art anzugeben, bei dem der Halbleiterkörper aus einem Teil einer Halbleiterscheibe besteht, die eine Vielzahl solcher Halbleiterkörper aufweist, ohne daß ein zeitaufwendiges und unübersichtliches Hantieren mit den einzelnen aus dieser Scheibe herauszutrennenden Halbleiterkörpern erforderlich ist. Das wird erfindungsgemäß durch eine Ausbildung des Verfahrens nach dem kennzeichnenden Teil des Patentanspruchs 1 erreicht.

Ein mit der Erfindung erzielbarer Vorteil liegt insbesondere darin, daß alle auf einer Halbleiterscheibe befindlichen Halbleiterkörper zunächst gemeinsam mit der ersten Kontaktierungsschicht und der Metallpulverschicht versehen werden, daß die Metallpulverschicht dann angesintert wird und daß erst hierdurch das Aufkleben der beschichteten Halbleiterrückseite auf eine Klebefolie zum Zwecke des Zersägens der Halbleiterscheibe möglich wird, so daß die vereinzelten Halbleiterkörper nach dem vollständigen oder teilweisen Zertrennen der Scheibe so lange in ihrer durch die Klebefolie gegebenen festen gegenseitigen Zuordnung gehalten werden, bis sie zum Befestigen auf einem Substrat von der Klebefolie abgezogen und bereitgestellt werden.

Die Patentansprüche 2 bis 6 sind auf bevorzugte Ausgestaltungen und Weiterbildungen des Verfahrens nach der Erfindung gerichtet.

In der Zeichnung zeigen:
Figur 1
eine schematische Darstellung zur Erläuterung eines bekannten Verfahrens,
Figuren 2 und 3
schematische Darstellungen zur Erläuterung des erfindungsgemäßen Verfahrens und
Figur 4
eine Darstellung zur Erläuterung einer vorteilhaften Weiterbildung des erfindungsgemäßen Verfahrens.

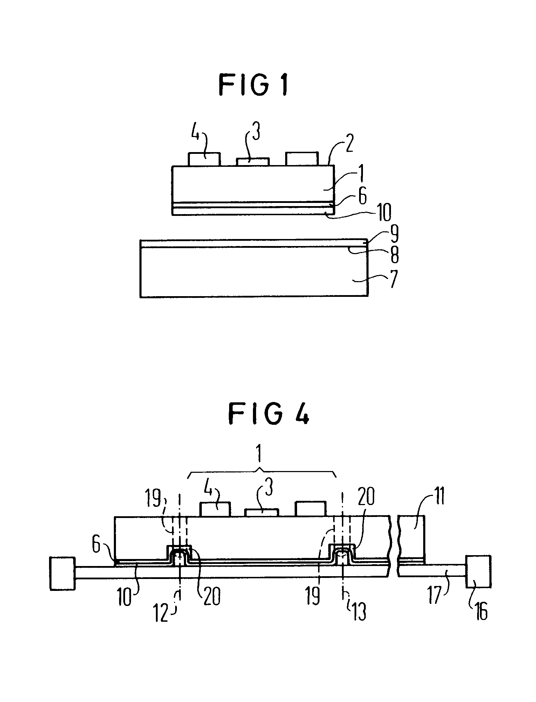

In Figur 1 ist ein Halbleiterkörper 1 aus dotiertem Halbleitermaterial, z.B. Si, im Schnitt dargestellt. Es handelt sich beispielsweise um einen Thyristor, der an seiner oberen Grenzfläche 2 mit Aluminiumstrukturen, und zwar mit einem Gatekontakt 3 und einer ringförmigen Kathodenelektrode 4 versehen ist. In den n-leitenden Halbleiterkörper 1 sind dabei zwei p-leitende Schichten, die jeweils die p-Basis und den p-Emitter darstellen, eingefügt, in die p-Basis weiterhin eine n-leitende Schicht, die den n-Emitter bildet und von der Kathodenelektrode 4 kontaktiert wird. Aus Gründen einer einfachen Darstellung sind diese in den Halbleiterkörper 1 eingefügten Schichten in Figur 1 nicht gezeigt. Die untere Grenzfläche von 1 ist mit einer Kontaktierungsschicht 6 belegt, die aus mehreren Teilschichten gebildet ist. Diese bestehen im einzelnen aus einer direkt auf die untere Grenzfläche von 1 aufgebrachten, 1 $\mu$m starken Aluminiumschicht, einer auf dieser aufgetragenen, etwa 100 nm dicken Titanschicht, einer über dieser liegenden, etwa 500 nm dicken Nickelschicht und einer diese abdeckenden, etwa 200 nm starken Silberschicht. Mit 7 ist ein Substrat bezeichnet, das aus Molybdän besteht. Die obere Begrenzungsfläche 8 des Substrats 7 ist mit einer Kontaktierungsschicht 9 versehen, die etwa 2 bis 3 $\mu$m dick ist und aus Silber besteht.

Zum Befestigen des Halbleiterkörpers 1 auf dem Substrat 7 wird nach einem der bekannten Verfahren so vorgegangen, daß auf der Kontaktierungsschicht 6 eine Metallpulverschicht 10 aufgetragen wird. Als Ausgangsstoff wird Silberpulver mit plättchenförmigen Pulverpartikeln einer Korngröße kleiner oder gleich 15 $\mu$m verwendet. Dieses Silberpulver wird in Cyclohexanol als Lösungsmittel im Gewichtsverhältnis von etwa 2:1 suspendiert. Die Paste wird dann nach dem Auftragen auf der Kontaktierungsschicht 6 durch Austreiben des Lösungsmittels getrocknet. Anschließend werden der Halbleiterkörper 1 und das Substrat 7 mit ihren die Kontaktierungsschichten 6 und 9 tragenden Grenzflächen unter Erhitzen zusammengepreßt, wobei sie auf eine Sintertemperatur von beispielsweise 230 °C gebracht und mit einem Druck von mindestens 900 N/cm$^2$ aufeinandergepreßt werden. Die Sinterzeit beträgt vorzugsweise eine Minute. Für den auf dem Substrat 7 befestigten Halbleiterkörper 1 nach Figur 1 stellt das Substrat 7 die Anodenelektrode dar.

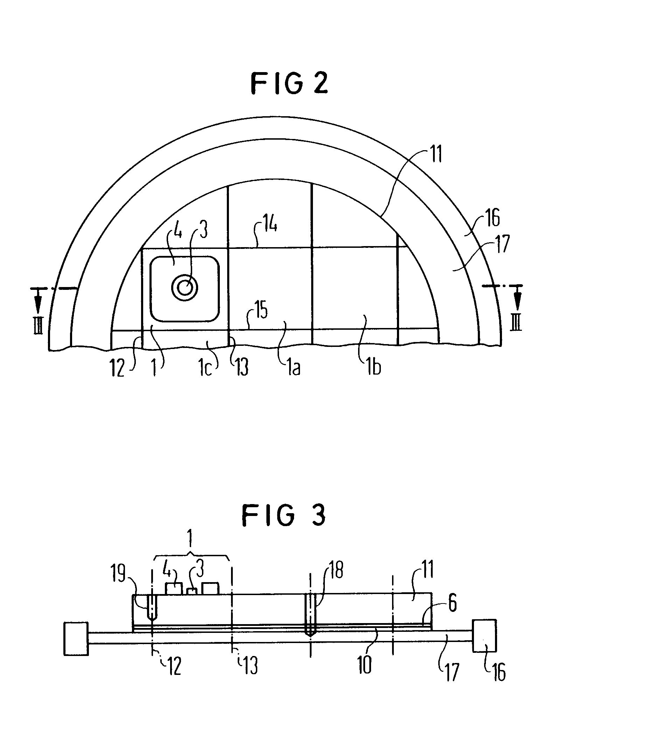

Gemäß Figur 2 ist der Halbleiterkörper 1 ein Teil einer Halbleiterscheibe 11, die eine Vielzahl solcher Halbleiterkörper, z.B. 1, 1a, 1b, 1c usw., aufweist. Diese sind durch Trennungslinien, z.B. 12 bis 15, gegeneinander abgegrenzt. Nach der Fertigstellung der durch die Strukturen 3 und 4 angedeuteten Halbleiterbauelemente wird nun die Halbleiterscheibe 11 auf eine in einem ringförmigen Rahmen 16 gehaltene Klebefolie 17 aufgeklebt. Dabei zeigt Figur 3 eine Schnittdarstellung entlang der Linie III-III von Figur 2. Würde man die aufgeklebte Halbleiterscheibe 11 entlang den Trennungslinien, z.B. 12 bis 15, zerteilen und jeden einzelnen der sich ergebenden Halbleiterkörper, z.B. 1, nach dem bekannten, anhand von Figur 1 erläuterten Verfahren mit der Silberpaste beschichten, so würde dies ein zeitaufwendiges und unübersichtliches Hantieren mit den einzelnen Halbleiterkörpern erfordern.

Nach der Erfindung wird so verfahren, daß auf der Rückseite der Halbleiterscheibe 11, die eine Vielzahl von mit integrierten Halbleiterbauelementen versehenen Halbleiterkörpern 1, 1a, 1b, 1c usw. aufweist, die Metallpulverschicht 10 für alle Halbleiterkörper gemeinsam aufgebracht wird. Diese Beschichtung erfolgt für die gesamte Halbleiterscheibe 11 entsprechend dem anhand von Figur 1 für einen einzelnen Halbleiterkörper erläuterten Verfahren. Anschließend wird die Metallpulverschicht 10, z.B. für eine Zeitspanne von 1 Minute, auf eine Sintertemperatur von z.B. 250°C erwärmt. Dabei versintert die Metallpulverschicht bereits so fest mit der Kontaktierungsschicht 6, daß sie durch eine Klebefolie nicht mehr abgerissen werden kann. Dann wird die Halbleiterscheibe 11 mit ihrer angesinterten Metallpulverschicht 10 in gewohnter Weise auf die Klebefolie 17 aufgeklebt und durch eine Wafersäge entlang den auf der Halbleitervorderseite markierten Trennungslinien, z.B. 12 bis 15, in die einzelnen Halbleiterkörper, z.B. 1 bis 1c, zerteilt. In Figur 3 ist dies durch einen Sägeschlitz 18, der bis in die Klebefolie 17 hineinreicht, angedeutet. Es ist aber auch möglich, die Halbleiterscheibe 11 an den Trennungslinien lediglich anzusägen, was durch einen nicht so tief eindringenden Sägeschlitz 19 angedeutet wird, und die unter diesen Sägeschlitzen verbleibenden Teile der Halbleiterscheibe 11 durch Verbiegen derselben durchzubrechen. In jedem Fall kann ein einzelner von der Halbleiterscheibe 11 abgetrennter Halbleiterkörper 1 anschließend von der Klebefolie 17 abgezogen und zur Befestigung auf einem Substrat 7 bereitgestellt werden, ohne daß die angesinterte Metallpulverschicht 10 beim Abziehen beschädigt wird.

Eine bevorzugte Weiterbildung des erfindungsgemäßen Verfahrens besteht darin, die Rückseite der Halbleiterscheibe 11 entlang den Trennungslinien, z.B. 12 und 13, vor dem Aufbringen der Kontaktierungsschicht 6 mit einem Netz von eingeätzten Gräben 20 zu versehen. Die Breite der Gräben 20 muß größer sein als die Schnittbreite der zum Herstellen der Sägeschlitze 18 oder 19 verwendeten Säge, während die Tiefe der Gräben 20 vorteilhafterweise der halben Schnittbreite entsprechen sollte, aber auch der Schnittbreite der Säge angeglichen werden kann. Durch diese Weiterbildung wird sicher vermieden, daß ein beim Sägen der Halbleiterscheibe 11 möglicherweise entstehender Sägegrat, der aus anhaftenden kleinen Randsplittern des einzelnen Halbleiterkörpers, z.B. 1, und aus verformten Überresten der Kontaktierungsschicht 6 oder der Metallpulverschicht 10 besteht, beim Verbinden des Halbleiterkörpers mit dem Substrat 7 in die Verbindungsebene gelangt. Der Sägegrat verbleibt bei einer mit den Gräben 20 versehenen Halbleiterscheibe 11 im Bereich dieser Gräben, so daß er den weiteren Verbindungsvorgang zwischen Halbleiterkörper und Substrat nicht nachteilig beeinflussen kann.

In Ergänzung der obengenannten Parameter beim Versintern der Metallpulverschicht 10 sei darauf hingewiesen, daß auch Sintertemperaturen ab 150°C bis etwa 300°C für eine Zeitspanne von z.B. 20 Minuten bis herunter auf etwa 0,1 Minute anwendbar sind.

Die Erfindung hat wesentliche Bedeutung sowohl für Leistungshalbleiter, wie z.B. Thyristoren oder Transistoren, als auch für Halbleiterbauelemente oder monolithisch integrierte Schaltkreise, die dort eingesetzt werden, wo eine sehr gute Wärmeableitung Voraussetzung für die Funktionsfähigkeit ist.

**Patentansprüche**

1. Verfahren zum Befestigen eines mit wenigstens einem Bauelement versehenen Halbleiterkörpers (1) auf einem Substrat (7), bei dem der Halbleiterkörper (1) auf einer Grenzfläche mit einer ersten Kontaktierungsschicht (6) versehen wird, bei dem eine Grenzfläche (8) des Substrats (7) mit einer zweiten Kontaktierungsschicht (9) versehen wird, bei dem auf der ersten Kontaktierungsschicht (6) eine Metallpulverschicht (10) aufgetragen wird und bei dem der Halbleiterkörper (1) und das Substrat (7) mit ihren die Kontaktierungsschichten (6, 9) tragenden Grenzflächen unter Erhitzen zusammengepreßt werden, **dadurch gekennzeichnet,** daß der Halbleiterkörper (1) aus einem Teil einer Halbleiterscheibe (11) besteht, die eine Vielzahl von gleichartigen oder ähnlichen Teilen aufweist, daß die erste Kontaktierungsschicht (6) und die Metallpulverschicht (10) auf der Rückseite der Halbleiterscheibe (11) für alle Halbleiterkörper gemeinsam aufgebracht werden, daß die Metallpulverschicht (10) für eine vorgegebene Zeitspanne auf eine Sintertemperatur erwärmt wird, daß die Halbleiterscheibe (11) anschließend mit der Rückseite auf eine Klebefolie (17) aufgeklebt wird, daß die Halbleiterscheibe (11) sodann entlang von den Halbleiterkörper (1) umgebenden Trennungslinien (12-15) an- oder durchgesägt wird, daß der Halbleiterkörper (1) nach dem vollständigen Abtrennen von der übrigen Halbleiterscheibe (11) von der Klebefolie (17) abgezogen und in der obengenannten Weise auf dem Substrat (7) befestigt wird und daß die Metallpulverschicht (10) durch eine entsprechende Bemessung der Zeitspanne und der Sintertemperatur an die erste Kontaktierungsschicht (6) so weit angesintert wird, daß der insoweit beschichtete Halbleiterkörper (1) unbeschädigt von der Klebefolie (17) abziehbar ist.

2. Verfahren nach Anspruch 1, **dadurch gekennzeichnet,** daß die Metallpulverschicht (10) während einer Zeitspanne von etwa 0,1 bis 20 Minuten und vorzugsweise von etwa 1 Minute auf der Sintertemperatur gehalten wird.

3. Verfahren nach Anspruch 1 oder 2, **dadurch gekennzeichnet,** daß die Sintertemperatur etwa 150°C bis 300°C und vorzugsweise etwa 250°C beträgt.

4. Verfahren nach einem der Ansprüche 1 bis 3, **dadurch gekennzeichnet,** daß die Halbleiterscheibe (11) vor dem Aufbringen der ersten Kontaktierungsschicht (6) auf ihrer Unterseite mit Gräben (20) versehen wird, die entlang den Trennungslinien (12, 13) des Halbleiterkörpers (1) verlaufen.

5. Verfahren nach Anspruch 4, **dadurch gekennzeichnet,** daß die Gräben (20) in die Halbleiterscheibe (11) geätzt werden.

6. Verfahren nach Anspruch 4 oder 5, **dadurch gekennzeichnet,** daß die Breite der Gräben (20) größer ist als die Schnittbreite einer zum Abtrennen des Halbleiterkörpers (1) verwendeten Säge und die Tiefe der Gräben (20) wenigstens der halben Schnittbreite entspricht.

## FIG 1

## FIG 4

FIG 2

FIG 3

Europäisches
Patentamt

EUROPÄISCHER
RECHERCHENBERICHT

Nummer der Anmeldung

EP 91 11 4776

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| Y | US-A-4 138 304   (F.G. GANTLEY)<br>* Spalte 4, Zeile 34 - Spalte 7, Zeile 65; Figuren 4-9 *<br>– – – | 1 | H 01 L 21/304<br>H 01 L 21/58 |
| D,Y | EP-A-0 242 626   (SIEMENS AKTIENGESELLSCHAFT)<br>* Spalte 4, Zeile 45 - Spalte 6, Zeile 28; Anspruch 1; Figuren 1-6 *<br>– – – | 1 | |
| A | PATENT ABSTRACTS OF JAPAN Band 6, Nr. 28 (E-95)(906), 19. Februar 1982;<br>& JP - A - 56148835 (MITSUBISHI DENKI) 18.11.1981<br>* das ganze Dokument *<br>– – – | 1 | |
| A | US-A-3 600 246   (J. BREEN)<br>* Spalte 2, Zeile 12 - Spalte 4, Zeile 9; Figuren 1-3 *<br>– – – | 1 | |
| A | PATENT ABSTRACTS OF JAPAN Band 8, Nr. 103 (E-244)(1540), 15. Mai 1984;<br>& JP - A - 59019335 (TOKYO SHIBAURA DENKI) 31.01.1984<br>* das ganze Dokument *<br>– – – | 1 | |
| A | EP-A-0 305 204   (XEROX CORPORATION)<br>* Zusammenfassung; Figur 3 *<br>– – – – – | 4-6 | RECHERCHIERTE SACHGEBIETE (Int. Cl.5)<br><br>H 01 L |

Der vorliegende Recherchenbericht wurde für alle Patentansprüche erstellt

| Recherchenort | Abschlußdatum der Recherche | Prüfer |
|---|---|---|
| Berlin | 31 Oktober 91 | LE MINH I |